# EUROPÄISCHE PATENTSCHRIFT

(11) **EP 1 018 162 B1**
(45) Veröffentlichungstag und Bekanntmachung des Hinweises auf die Patenterteilung: **03.05.2006**
(21) Anmeldenummer: 98952540.7
(22) Anmeldetag: 28.08.1998
(51) Int. Cl.: H01L 25/04, H01L 31/105

(54) **MEHRFARBENSENSOR**
MULTICOLOR SENSOR
DETECTEUR DE PLUSIEURS COULEURS

(30) Priorität: 28.08.1997 DE 19737561
(43) Veröffentlichungstag der Anmeldung: 12.07.2000
(73) Patentinhaber: Forschungszentrum Jülich GmbH, 52425 Jülich (DE)
(72) Erfinder: STIEBIG, Helmut, D-52428 Jülich (DE); KNIPP, Dietmar, D-53773 Hennef (DE); FÖLSCH, Joachim, D-63755 Alzenau (DE); WAGNER, Heribert, D-52428 Jülich (DE)
(86) Internationale Anmeldenummer: PCT/DE1998/002598
(87) Internationale Veröffentlichungsnummer: WO 1999/012206

(56) Entgegenhaltungen:
- WO-A-96/13865
- US-A- 4 875 944
- US-A- 5 311 047
- TOPIC M ET AL: "Stacked a-SiC:H/a-Si:H heterostructures for bias-controlled three -colour detectors" JOURNAL OF NON-CRYSTALLINE SOLIDS, Bd. 198-200, Mai 1996, Seite 1180-1184 XP004079646 in der Anmeldung erwähnt
- CESARE DE G ET AL: "VARIABLE SPECTRAL RESPONSE PHOTODETECTOR BASED ON CRYSTALLINE/ AMORPHOUS SILICON HETEROSTRUCTURE" JOURNAL OF NON-CRYSTALLINE SOLIDS, Bd. 198/200, Nr. PART 02, 1. Mai 1996, Seiten 1189-1192, XP000621439

## Beschreibung

Die Erfindung betrifft einen Mehrfarbensensor. Desweiteren betrifft die Erfindung ein optoelektronisches Bauelement und eine CCD enthaltende Videokamera.

Als Stand der Technik sind Zwei-Terminalbauelemente bekannt. Diese optoelektronischen Bauelemente enthalten dazu zwei Kontakte (Terminals) mit einer zwischenliegenden p-n-Halbleiterstruktur zur Ausbildung eines Photostroms bei Lichteinfall. Nachteilig muß die Spannung geschaltet werden, so daß das Rot-Grün-Blau(RGB)-Signal zeitlich nur sequentiell ermittelt werden kann.

Einerseits ist in diesem Zusammenhang eine nipin-Schichtstruktur als photoempfindliches elektrisches Bauelement mit zwei aussenliegenden Kontakten auf der Basis von amorphem Silizium bereits aus US-Patent 53 11 047 bekannt. Andererseits wurde in DE 196 13 820.5-33 eine piiin-Struktur als photoempfindliches elektrisches Bauelement mit zwei aussenliegenden Kontakten auf der Basis von amorphem Silizium vorgeschlagen.

Zudem sind als Stand der Technik Drei-Terminalbauelemente bekannt. Erste Vorschläge zur Bildung einer pin/TCO/nipin-Struktur als Drei-Terminalbauelement wurden in M. Topic, F. Smole, J. Furlan, W. Kusian, J. of Non-Cryst. Solids 198-299 (1996) 1180-1184 bereits publiziert. Auch hier muß jedoch nachteilig die Spannung sequenziell geschaltet werden.

Schließlich sind sogenannte Charge Coupled Devices (CCD) bekannt, bei denen jedoch nachteilig der Farb-Moiree-Effekt die digitale Signalaufnahme erschwert.

Bei den genannten Strukturen zur Bildung solcher Zwei- oder Drei-Terminalbauelemente kann die Absorberschicht der einzelnen Diode in Abhängigkeit der zu beabsichtigten Farbseparation entsprechend eingestellt werden.

Die bisher bekannten vertikal integrierten Farbdetektoren basieren darauf, daß sequentiell die am Detektor anliegende Spannung gewechselt werden muß um die komplette Farbinformation zu erhalten. Hierzu sind wenigstens drei oder sogar mehr Schaltspannungen erforderlich.

Es ist deshalb Aufgabe der Erfindung einen Mehrfarbensensor in Dünnschichttechnologie zu schaffen, wobei ein sequentieller Wechsel der am Detektor anliegenden Spannung zur Erhaltung der vollständigen Farbinformation nicht erforderlich ist.

Die Aufgabe wird gelöst durch einen Mehrfarbensensor gemäß der Gesamtheit der Merkmale nach Anspruch 1. Weitere zweckmäßige oder vorteilhafte Ausführungsformen finden sich in den auf diesen Anspruch rückbezogenen Unteransprüchen.

Die Aufgabe wird erfindungsmäßig so gelöst, daß ein Bauelement aus einer Mehrzahl, vorzugsweise drei Stück, von schichtförmig gebildeten Diodenfunktionen, beispielsweise pin-, nip-, npin- und / oder pnip-Diodenfunktionen gebildet sein, die senkrecht zur Lichteinfallsrichtung angeordnet und miteinander verbunden sind.

Im einzelnen handelt es sich beim erfindungsgemäßen Bauelement vor allem um ein solches auf der Basis von amorphem Silizium und dessen Legierungen, microkristallinem Silizium und dessen Legierungen sowie u.u. transparenten leitfähigen Kontaktschichten. Die erfindungsgemäße Schichtenfolge sowie das erfindungsgemäße Bauelement ermöglichen ein gleichzeitiges (paralleles) Auslesen der Photoströme der vertikal integrierten Dioden, sodaß an ein und dem selben Ort (in einer Array-Anordnung als Pixel bezeichnet) mehrere Farbsignale gleichzeitig, beispielsweise als vollständiges Rot-Blau-Grün(RGB)-Signal detektiert werden können. Die spektrale Empfindlichkeit dieses Bauelements kann durch ein geeignetes Design der einzelnen Diodenfunktionen durch einstellen bestimmter Parameter wie zum Beispiel die jeweilige Schichtdicke, vom nahen Ultravioletten bis zum nahen Infraroten Bereich eingestellt werden.

Die Erfindung basiert darauf, ein Bauelement zu entwikkeln, daß durch eine dreidimensionale Integration eine vertikale Farbdetektion erlaubt, wobei die komplette Farbinformation je Pixel parallel auslesbar ist. Da die in Lichteinfallsrichtung vorgeschalteten Diodenfunktionen den darunter liegenden Diodenfunktionen als Absorber dienen, erübrigt sich in vorteilhafter Weise den Einsatz weiterer optischer Filter.

Zur Realisierung von beispielsweise einem erfindungsgemäßen 4-Terminal-Bauelement muß die optische Absorption der einzelnen Dioden mit zunehmender Eindringtiefe und Wellenlänge der Photonen des eingestrahlten Lichtes zunehmen. Das Detektionskonzept basiert darauf, daß in der ersten Diode das kurzwellige Licht (z.B. blaues Licht) und in der hinteren Diode langwelliges Licht absorbiert wird, dies gilt unabhängig von der gewählten Schichtstruktur der Einzeldioden (z.B. nip, nipin, npin, pinip, pnip, oder pin).

Durch die Berücksichtigung von npin- oder pnip-Diodenstrukturen kann auf beiden Seiten einer transparenten Kontaktschicht jeweils eine dotierte Halbleiterschicht, insbesondere als p-dotierte oder n-dotierte Schicht angeordnet sein. Somit wird über die leitfähige Kontaktschicht, die vorzugsweise als TCO-Schicht gebildet ist oder aus mikrokristallinem p- oder n-leitendem Material besteht, nur eine Ladungsträgersorte injiziert oder eingesammelt werden, da am folgenden p/n- oder n/p-Heteroübergang der Ladungsträgerwechsel stattfindet.

Durch den Übergang von einem Zwei-Terminal zu einem Vier-Terminal-Bauelement können alle drei RGB-Signale gleichzeitig - und damit nicht sequenziell - ausgelesen werden.

Der erfindungsgemäße Mehrfachsensor und das erfindungsgemäße Bauelement weisen den Vorteil auf, durch die vertikale Integration des Bauelements bei gleichzeitiger Detektion des aufzunehmenden Signals (zur Detektion von z.B. der Farben Blau, Grün und Rot) der Farb-Moiree-Effekt vermieden wird (wie bei Verwendung von CCD-Kameras durch die Verwendung von räumlich angeordneten Farbfilter üblich). Zudem kann dabei in vorteilhafter Weise mit Hilfe einer sogenannten One-shot-Aufnahme ein hinsichtlich der Farberfassung vollständiges Signal zur digitalen Bildverarbeitung zur Verfügung gestellt werden.

Die Erfindung ist im weiteren an Hand von Figuren und Ausführungsbeispielen näher erläutert. Es zeigt:
- Fig. 1:: Schematische Darstellung eines vertikal integrierten erfindungsgemäßen Farbdetektors aus amorphem oder mikrokristallinem Silizium mit 3 Diodenfunktionen, bei dem die Grundfarben Blau, Grün und Rot parallel auslesbar sind;
- Fig. 2:: Relative spektrale Empfindlichkeit eines erfindungsgemäßen 4-Terminal-Bauelements;
- Fig. 3:: Defektdichte N_{D} als Funktion des optischen Bandabstandes für a-Si₁₋ₓGeₓ:H; In der Einfügung ist der optische Bandabstand als Funktion des Ge-Gehaltes im Material dargestellt;
- Fig. 4:: Photo- (AM 1.5) und Dunkelleitfähigkeit als Funktion des optischen Bandabstandes für a-Si₁₋ₓGeₓ:H;
- Fig. 5:: Ambipolare Diffusionslänge L_{ambi} als Funktion des optischen Bandabstandes für a-Si₁₋ₓGeₓ:H, zum Vergleich mit Werten aus der Literatur [3, 4, 5];
- Fig. 6:: Photoleitfähigkeit als Funktion des optischen Bandgaps für a-SiC:H, hergestellt aus einem Silan/Methan-Gemisch, mit und ohne Wasserstoffverdünnung (Kreise aus [6] und Quadrate aus [2];
- Fig. 7:: Schematischer Aufbau eines erfindungsgemäßen 4-Terminal-Bauelements auf der Basis einer pinipin-Struktur mit mikrokristallinen Kontaktschichten;
- Fig. 8a:: Draufsicht eines schematischen Aufbaus einer invertiert ausgebildeten erfindungsgemäßen Detektorstruktur eines 4-Terminal-Bauelements;
- Fig. 8b:: Schnitt durch einen schematischen Aufbau einer invertiert ausgebildeten erfindungsgemäßen Detektorstruktur eines 4-Terminal-Bauelements;
- Fig. 9:: Schematische Darstellung eines erfindungsgemäßen 2D-Arrays mit Hilfe von aus den Figuren 8a, 8b entnehmbaren, jeweiligen 4-Terminalbauelementen zur gleichzeitigen Generation eines RGB-Signals;

### Ausführungsbeispiel

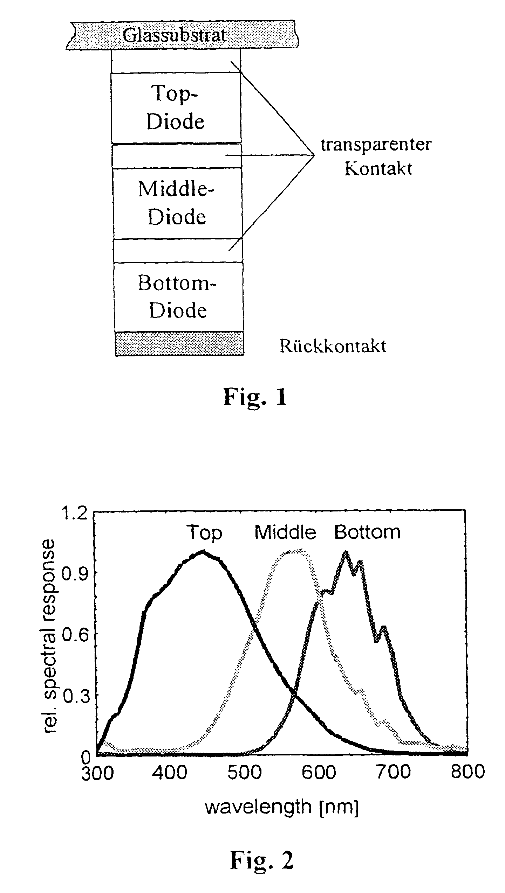

In der Figur 1 ist die schematische Darstellung eines vertikal integrierten Farbdetektors aus amorphem oder mikrokristallinem Silizium mit drei Dioden gezeigt, bei dem die Grundfarben (Blau, Grün, Rot) parallel ausgelesen werden können.

Der in der Figur 1 gezeigte schematische Aufbau der erfindungsgemäßen Detektorstruktur besteht dabei aus drei Dioden zur Erzeugung eines RGB-Signals, die auf einem Glassubstrat hergestellt wurden. Auf dem transparenten Frontkontakt, der z.B. mittels einer ZnO-, SnO₂- oder ITO-Schicht gebildet werden kann, wird eine erste Detektorstruktur (Top-Diode) abgeschieden, welche blaues Licht absorbiert. Anschließend erfolgt das Aufbringen eines weiteren transparenten Kontaktes (z.B. ZnO-, SnO₂- oder ITO-Schicht), auf dem ebenfalls eine farbselektive Diode (Middle-Diode) abgeschieden wird. Die Diode detektiert grünes Licht. Diese Anordnung wiederholt sich für die dritte Diode (Bottom-Diode), die das langwellige Licht des Spektrums (Rot) absorbiert.

In der Figur 2 ist die spektrale Empfindlichkeit eines 4-Terminal-Bauelements in einer pin/nip/pin-Anordnung mit der maximalen spektralen Empfindlichkeit der Top-diode bei 450 nm, der Middlediode bei 565 nm und der Bottomdiode bei 640 nm dargestellt.

Für den Fall, daß mehr als drei Dioden realisiert werden, kann sich dieser Vorgang entsprechend wiederholen. Abgeschlossen wird das Detektorsystem durch einen Rückkontakt. Die Strukturierung der Multischicht-Struktur kann beispielsweise mittels Standardphotolithographie und reaktivem Ionenätzen erfolgen.

Dabei können die einzelnen Dioden von der Lichtseinfallsrichtung zum Rückkontakt in einer beliebigen Kombination der Einzeldioden angeordnet werden. Beispielsweise läßt sich für ein 4-Terminalbauelement zum Beispiel die Schichtaufbauten nip/nip/nip, pin/pin/pin, pin/nip/pin, nip/pin/nip oder eine andere Kombination aus pin/npin/npin/ oder pin/npin/nip usw. realisieren.

Die spektrale Empfindlichkeit der einzelnen Dioden kann durch die Verwendung von Material mit unterschiedlichem Bandgap, Verwendung eines entsprechenden Bandlückendesigns der Absorberschichten (beispielsweise u-form, v-form Gradierung der Bandlücke innerhalb der Absorberschicht wie zum Beispiel a-SiₓGeₓ:H, Wasserstoffkonzentration oder der Einsatz von einem Buffer, Variation der einzelnen Schichtlängen der aktiven Absorberschichten als auch der nicht aktiven Kontaktschichten (n- und p-Schichten) entsprechend den Anforderungen angepaßt werden.

Basierend auf den vorangenannten Optimierungskriterien können die Absorberschichten der einzelnen Dioden so gewählt sein, daß das Produkt aus Schichtdicke und Wellenlänge mit ansteigender Wellenlänge von der Lichteinfallsrichtung bis zum Rückkontakt in der jeweiligen aufeinanderfolgenden Schicht zunehmend ausgebildet ist.

Die optoelektronischen Eigenschaften der erfindungsgemäßen Schichtenfolge, des Sensors bzw. des Bauelements lassen sich durch folgende Maßnahmen verändern:
a) Einbau von Germanium oder Kohlenstoff in das amorphe Siliziumnetzwerk (a-SiGe:H, a-Si(C):H ;
b) Zugabe von Wasserstoff bzw. Variation der Wasserstoffkonzentration bei den Prozeßgasen sowohl für a-Si:H als auch für dessen Legierungen (Punkt a);
c) Einbau von mikrokristallinen Schichten auf der Basis von Silizium und Germanium;
d) Einbau von Schichten mit hoher Wasserstoffverdünnung und niedriger Abscheidetemperatur (Ts = 120-160°C).

Zum Einfluß der Herstellungsbedingungen auf die Transporteigenschaften von a-Si:H basierenden Legierungen im Rahmen der Erfindung wird folgendes ausgeführt:

Bei amorphem Silizium (a-Si:H) lassen sich die optoelektronischen Eigenschaften durch Variation der Herstellungsbedingungen beeinflussen. Beispielsweise kann die Materialqualität durch Variation des Depositionsdrucks, der Temperatur, der zugeführten elektrischen Leistung oder durch geeignete Beigabe von zusätzlichen Prozeßgasen (wie zum Beispiel Wasserstoff, Helium, Argon oder Fluor) bei der Schicht-Deposition verändert werden. Dies bedeutet, daß die Ladungsträger-Transporteigenschaften (d.h. das Produkt aus Ladungsträger-Lebensdauer und Ladungsträger-Beweglichkeit sowie die ambipolare Diffusionslänge) über einen gewissen Bereich gezielt eingestellt werden können.

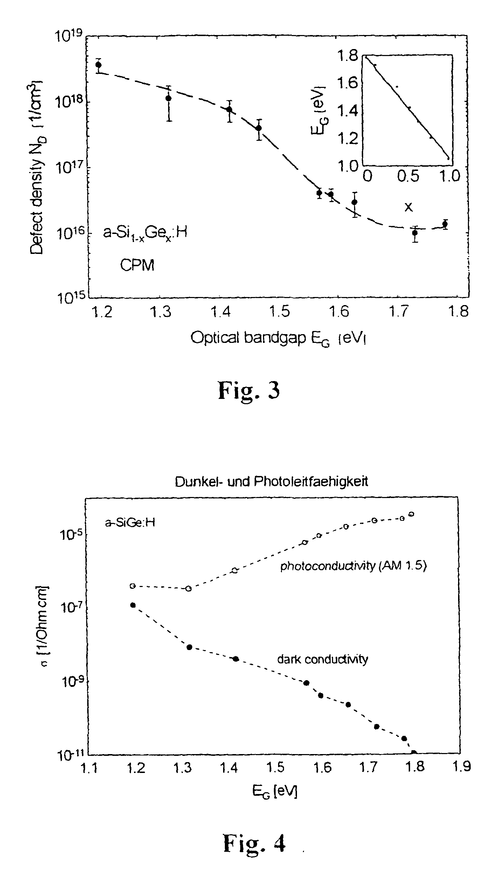

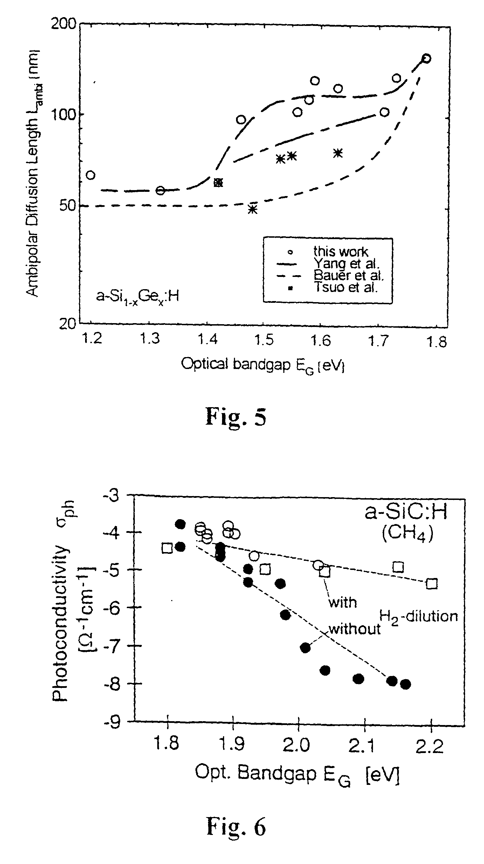

Bei den Legierungen des amorphen Siliziums, wie z. B. den Silizium-Germanium-(a-Si₁₋ₓGeₓ:H) und den Silizium-Kohlenstoff-Legierungen (a-Si₁₋ₓCₓ:H), ändern sich die Transporteigenschaften zum Teil sehr stark, schon mit der Zusammensetzung der jeweiligen Legierung. Dieses Verhalten ist am Beispiel der Silizium-Germanium-Legierung in den Figuren 3 bis 5 dargestellt. Mit zunehmendem Germaniumgehalt läßt sich der optische Bandabstand kontinuierlich zwischen E_{G} ≈ 1,8 eV (a-Si:H) und E_{G} ≈ 1,0 eV (a-Ge:H) einstellen (siehe Einfügung Figur 3). Mit zunehmender Ge-Konzentration steigt die Defektdichte, ermittelt mit dem Meßverfahren "Constant Photocurrent Method", um bis zu zwei Größenordnungen an (Figur 3, großes Bild). Gleichzeitig verändern sich die Photo- und die Dunkelleitfähigkeit (siehe Figur 4) sowie die ambipolare Diffusionslänge (siehe Figur 5) in Abhängigkeit von der Legierungszusammensetzung.

Die Photoleitfähigkeit ist proportional zum Produkt aus Ladungsträger-Lebensdauer τ und Beweglichkeit µ und spiegelt die Transporteigenschaften der Majoritätsladungsträger (hier: Elektronen) wieder. Die ambipolare Diffusionslänge beschreibt für das hier vorliegende Material im wesentlichen Transporteigenschaften der Minoritätsladungsträger (hier: Löcher).

Darüber hinaus können (wie beim a-Si:H) bei den Siliziumlegierungen durch präparative Maßnahmen, insbesondere durch die Zugabe zusätzlicher Prozeßgase während der Deposition, die Transporteigenschaften beeinflußt werden. Als Beispiel ist in Figur 6 für das Legierungssystem a-Si₁₋ₓCₓ:H der Einfluß von Wasserstoffzugabe ("Wasserstoffverdünnung") zu den Prozeßgasen Silan (SiH₄) und Methan (CH₄) dargestellt. Mit starker Wasserstoffverdünnung hergestelltes Material zeigt eine wesentlich größere Photoleitfähigkeit und damit höhere Werte für das µτ-Produkt als ohne H₂-Zugabe deponiertes Material. Dieser Effekt nimmt mit zunehmendem Kohlenstoffgehalt im Material stark zu. Das Verhältnis [H₂)/([SiH₄]+[CH₄]) kann dabei Werte von 10 bis 50 annehmen.

Eine weitere Möglichkeit im Rahmen der Erfindung Material mit größerem Bandgap und guten optoelektronischen Eigenschaften herzustellen, liegt in der Verwendung von hoher Wasserstoffverdünnung (vorzugsweise 4 - 30fach) und einer niedrigen Abscheidetemperatur (vorzugsweise bei einer Temperatur im Bereich von 120°C bis 160°C). Unter diesen Depositionsbedingungen läßt sich im Rahmen der Erfindung eine Bandlücke im Bereich zwischen 1.8 eV und 1.95 eV einstellen.

Durch Verwendung von mikrokristallinen Kontaktschichten (n- und p-Schichten) kann gegebenfalls teilweise oder vollständig auf die TCO-Schichtem zwischen den einzelnen Dioden (z.B. pin/TCO/pin/TCO/pin) verzichtet werden, da sie eine deutlich höhere Leitfähigkeit und andererseits eine deutlich längere Ätzrate (z.B. bzg. reaktivem Ionenätzen) als a-Si:H-Schichten besitzen.

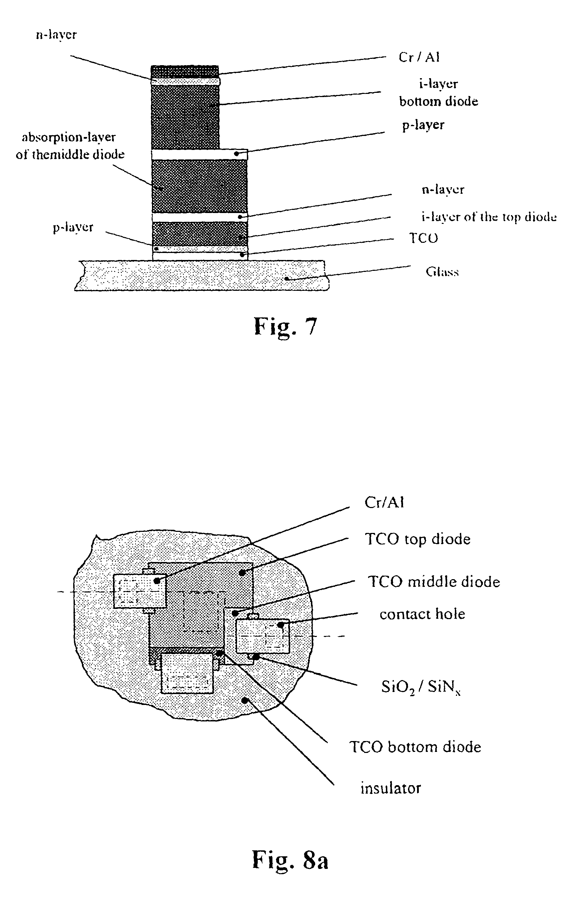

Eine solche erfindungsgemäße Anordnung, wie in Figur 7 als pinipin-Struktur mit mikrokristallinen Kontaktschichten dargestellt ist, führt ebenfalls zu einer möglichen Kontaktierung der einzelnen Dioden. Wie aus der Figur 7 entnehmbar wurde die innenliegende p-Schicht zur Ausbildung als innenliegenden Kontakt (Terminal) durch geeignete Strukturierung teils freiliegend ausgebildet um die Kontaktierung zu ermöglichen. Aufgrund der unterschiedlichen Selektivität von mikrokristallinem und amorphem Silizium während des Ätzprozesses läßt sich das Dünnfilmbauelement strukturieren und somit realisieren. Diese Struktur bietet neben der in Figur 1 vorgeschlagenen Anordnung den Vorteil, daß auf die TCO-Schichten verzichtet und somit die Anzahl an dotierten Schichten reduziert werden kann. Dadurch dann eine Vereinfachung des Aufbaus erreicht werden.

Aufwendigere Mehr-Terminal-Strukturen, bei denen komplexere Schichtfolgen wie z.B. nipin- oder pinip-Dioden zwischen den transparenten Kontakten eingebettet werden, erlauben zwar die Detektion unabhängiger linearer spektraler Verläufe, die für eine Weiterverarbeitung erforderlich sind, aber das Bauelement kann nicht parallel ausgelesen werden, es sei denn, man realisiert n ≥ 3 Dioden und nutzt die einstellbare spektrale Empfindlichkeit einer Diode applikationsspeziefisch. Je nach Anwendung läßt sich die spektrale Empfindlichkeit entsprechend einstellen. Während eines Auslesezyklusses muß jedoch gewährleistet sein, daß man ein RGB-Signal ohne Wechsel der an den Detektor angelegten Spannung ausgelesen werden kann.

Als Beispiel ist es vorstellbar, die Middle-Diode eines Vier-Terminal-Bauelements als pinip-Struktur realisieren. Diese Stuktur kann dann jeweils anwendungsbezogen unter einer positiven oder negativen Spannung ausgelesen werden. Der Vorgang des parallelen Auslesens ist hiervon nicht betroffen. Eine solche Struktur bietet neben der einstellbaren grün Empfindlichkeit eine weitere Optimierungsmöglichkeit. Durch die zusätzlich eingefügten Schichten ergeben sich Freiheitsgrade im Design der Struktur, so daß die spektrale Empfindlichkeit mehr an ein Standard RGB-Signal angepaßt werden kann. Diese Möglichkeiten liegen im Bereich der optischen Anpassung und der Auskopplung von bestimmten Spektralbereichen des einfallenden Lichts.

Alternativ zu einer erfindungsgemäßen Detektorstruktur, welche auf einem Glassubstrat mit einem leitfähigen transparenten Frontkontakt deponiert werden kann, läßt sich das Multischichtsystem auch auf unterschiedlichen Substraten (z.B. Ag, Al, oder einem Siliziumwafer, der z.B. die Ausleseelektronik enthalten kann) invertiert abgescheiden.

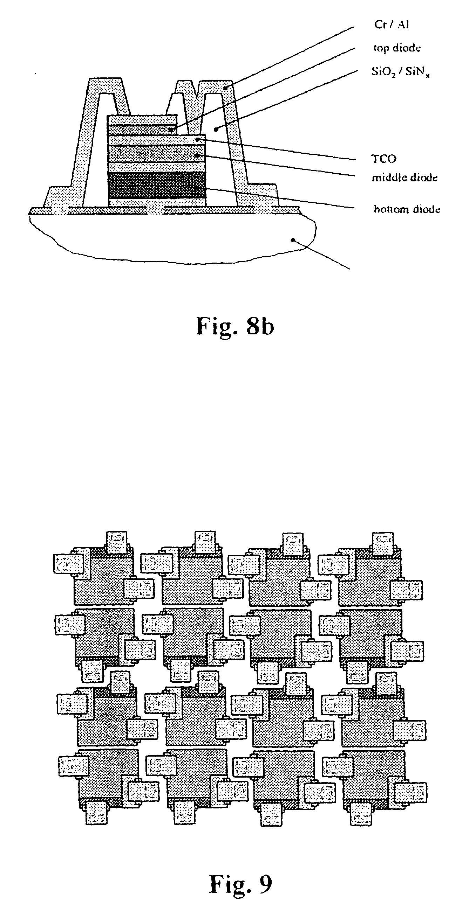

Die Figur 8 zeigt einen möglichen schematische Aufbau einer invertiert hergestellten Detektorstruktur in Draufsicht (Abb. 8a) und einem Schnitt durch die Multischichtstruktur (Abb. 8b). Beispielsweise kann auf einen elektronischen Schaltkreis auf der Basis kristallinem Siliziums, der durch einen strukturierten Isolator von dem Dünnfilmdetektorsystem getrennt wird, das Detektorsystem deponiert werden. Nach der Strukturierung des amorphen oder mikrokristallinen Schichtsystems wird eine weitere Isolationsschicht (SiO₂, SiNₓ oder Polymid) in einem PECVD-Prozeß aufgebracht und ebenfalls strukturiert. Die Realisierung der Kontakte zwischen den einzelnen Detektor und der Ausleseelektronik erfolgt mittels einer Metallisierung (z.B. Ag), die in einem Lift-off Prozeß strukturiert wird. Neben der Realisierung eines einzelnen Detektors kann auch ein Zeilensensor oder ein 2-dimensionales Array mit diesen Bauelementen realisiert werden. Die mögliche Realisierung eines 2D-Arrays ist schematisch in Figur 9 dargestellt.

### Literaturliste

[3] W. Luft, Y.S. Tsuo in: *Hydrogenated Amorphous Silicon Alloy deposition processes,* Marcel Dekker Inc., New York, Basel, Hong Kong, (1993).
[4] G.H. Bauer, C.E. Nebel and H.-D. Mohring, Mat. Res. Soc. Symp. Proc. **118,** 679 (1988).
[5] L. Yang, L. Chen, A. Catalano, Mat. Res. Soc. Symp. Proc. **219**, 259 (1991).
[6] J. Fölsch, Dissertation, Universität Stuttgart 1995, in: *Berichte des Forschungszentrums Jülich, Jül-*3147 (1995)

## Patentansprüche

1. Mehrfarbensensor mit wenigstens drei Diodenfunktionen enthaltenden Schichtenfolgen, wobei diese Schichtenfolgen durch leitfähige innenliegende Kontaktschichten voneinander getrennt sind und nach außen ebenfalls durch leitfähige Kontaktschichten begrenzt sind, und wobei
a) die Kontaktschichten mit elektrischen Kontakten versehen sind, und
b) eine weitere Schicht zwischen einer inneren Kontaktschicht und der ihr benachbarten Diodenfunktionen enthaltenden Schichtenfolge zur Bildung eines zusätzlichen n/p- oder p/n-Heteroübergangs vorgesehen ist, die das Einsammeln oder injizieren von nur einer Ladungsträgersorte über diese innere Kontaktschicht bewirkt.

2. Mehrfarbensensor nach vorhergehendem Anspruch,
**gekennzeichnet durch**
pin-, nip-, npin- und/oder pnip-Strukturen zur Bildung der Diodenfunktionen.

3. Mehrfarbensensor nach einem der vorhergehenden Ansprüche,
**dadurch gekennzeichnet,**
**daß** die innenliegenden p- oder n-Schichten zur Kontaktschichtbildung mikrokristallin ausgebildet sind.

4. Mehrfarbensensor nach einem der vorhergehenden Ansprüche,
**dadurch gekennzeichnet,**
**daß** bei benachbarten, innenliegenden p- und n-Schichten lediglich eine der beiden p- und n-Schichten mikrokristallin ausgebildet ist.

5. Bauelement mit einem eine Mehrzahl von Mehrfarbensensoren nach einem der vorhergehenden Ansprüche enthaltenden 2D-Array.

6. CCD enthaltende Videokamera mit einem Bauelement nach einem der Ansprüche 1 bis 5.

## Claims

1. Multi-colour sensor comprising layer sequences which include at least three diode functions, and these layer sequences are separated from one another by conductive interior contact layers, and they are also outwardly defined by conductive contact layers, and
a) the contact layers are provided with electrical contacts, and
b) a further layer between an inner contact layer and its adjacent layer sequence including adjacent diode functions is provided for forming an additional n/p or p/n hetero transfer which causes collection or injection of only one kind of charge support over said internal contact layer.

2. Multi-colour sensor according to the above claim, **characterised by** pin-, nip-, npin- and/or pnip structures for establishing the diode functions.

3. Multi-colour sensor according to one of the above claims, **characterised in that** the internal p- or n-layers are of micro-crystalline design for the purpose of forming a contact layer.

4. Multi-colour sensor according to one of the above claims, **characterised in that**, in the case of adjacent internal p- and n-layers, only one of the two p- and n-layers is microcrystalline.

5. Assembly element with a 2D-array, containing a plurality of multi-colour sensors according to one of the above claims.

6. Video camera containing CCD with an assembly component according to one of Claims 1 to 5.

## Revendications

1. Capteur multicolore comprenant au moins trois successions de couches contenant des fonctions de diodes, ces successions de couches étant séparées les unes des autres par des couches de contact internes conductrices et étant délimitées vers l'extérieur également par des couches de contact conductrices, et
a) les couches de contact étant pourvus de contacts électriques, et
b) une autre couche, qui réalise la collecte ou l'injection d'une seule variété de porteur de charge au-dessus de cette couche de contact interne.

2. Capteur multicolore selon l'une quelconque des revendications précédentes, **caractérisé par** des structures pin, nip, npin et/ou pnip pour former les fonctions de diodes.

3. Capteur multicolore selon l'une quelconque des revendications précédentes, **caractérisé en ce que** les couches internes p ou n destinées à former la couche de contact présentent une configuration microcristalline.

4. Capteur multicolore selon l'une quelconque des revendications précédentes, **caractérisé en ce que** dans le cas des couches internes et voisines p et n, une seule des deux couches p et n est conçue de façon microcristalline.

5. Composant comprenant un réseau 2D contenant une pluralité de capteurs multicolores selon l'une quelconque des revendications précédentes.

6. Caméra CCD comprenant un composant selon l'une quelconque des revendications 1 à 5.
